Europäisches Patentamt

European Patent Office

Office européen des brevets

(11) Veröffentlichungsnummer: **0 344 805 B1**

## EUROPÄISCHE PATENTSCHRIFT

(45) Veröffentlichungstag der Patentschrift: **29.12.93**

(51) Int. Cl.⁵: **H03C 1/00**, H03H 5/00, H04H 5/00

(21) Anmeldenummer: **89110044.8**

(22) Anmeldetag: **02.06.89**

(54) **Geschalteter Modulator.**

(30) Priorität: **03.06.88 HU 1419488**
**03.06.88 HU 1419588**

(43) Veröffentlichungstag der Anmeldung:
**06.12.89 Patentblatt 89/49**

(45) Bekanntmachung des Hinweises auf die
Patenterteilung:
**29.12.93 Patentblatt 93/52**

(84) Benannte Vertragsstaaten:
**AT BE CH DE FR GB IT LI NL SE**

(56) Entgegenhaltungen:
**DE-A- 3 630 117**
**GB-A- 2 118 384**
**US-A- 3 136 860**

**FUNKSCHAU, Band 57, Nr. 2, Januar 1985,
Seiten 53-54, München, DE; W. MOORTGAT-
PICK et al.: "Rundfunk-Stereo-Übertragung
(UKW-Stereophonie)"**

(73) Patentinhaber: **Rohde & Schwarz GmbH & Co.
KG
Mühldorfstrasse 15
D-81671 München(DE)**

(72) Erfinder: **Hercz, Endre
Papir u. 45
H-1165 Budapest(HU)**
Erfinder: **Sziebold, Peter
Bàr Tibor u. 5
H-1043 Budapest(HU)**

(74) Vertreter: **Graf, Walter, Dipl.-Ing.
Sckellstrasse 1
D-81667 München (DE)**

## Beschreibung

Die Erfindung betrifft einen geschalteten Modulator laut Oberbegriff des Hauptanspruches, wie er insbesondere zur Erzeugung von nach dem Pilottonverfahren codierten Stereotonsignalen geeignet ist.

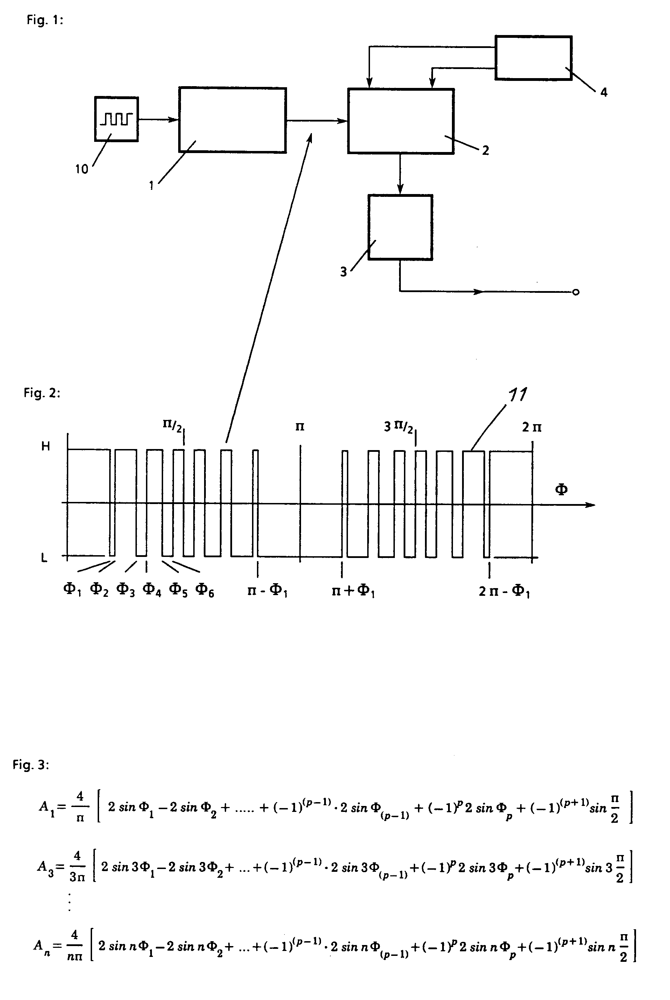

Ein Modulator dieser Art ist bekannt (Proceedings of the RF-Technology Expo, 87, Anaheim, California, E. HERCZ und P. SZIEBOLD: "Mixed Digital Method for Producing Pilot-Tone Stereo Signal," CARDIFF PUBLISHING COMPANY, S. 61-68). Der elektronische Schalter wird hierbei mit einer in einem digitalen Impulsgenerator erzeugten Ausgangsimpulsfolge gesteuert, bei welcher die Anzahl und die Abstände der aufeinanderfolgenden Signalwechsel so gewählt sind, daß von der Wiederholfrequenz, die der Trägerfrequenz entspricht, nur Harmonische höherer Ordnung entstehen, die oberhalb der Grenzfrequenz eines dem elektronischen Schalter nachgeschalteten Tiefpaßfilters liegen. Die Ausgangsimpulsfolge des Impulsgenerators zeigt Fig. 2. Es handelt sich hierbei um ein symmetrisches Impulssignal, für das die Beziehung

(I)     $a(\Phi + \pi) = -a(\Phi)$

und

(II)     $a(\pi - \Phi) = -a(\Phi)$

gilt. Der Wert aller geraden Harmonischen eines solchen symmetrischen Signals ist Null, die Faktoren der ungeraden Harmonischen können nach bekannten Gleichungen hergeleitet werden. Aus dem Gleichungssystem nach Fig. 3 können p Gleichungen beliebig ausgewählt und damit p Unbekannte bestimmt werden, bei Vorgabe von p Harmonischen also z.B. p Phasenwinkel $\Phi$ ausgerechnet werden.

Für einen Modulator, der mit einer Trägerfrequenz von 38 kHz arbeitet, wurde davon ausgegangen, daß der Pegel der anfänglichen Harmonischen kleiner als 60 dB und erst die 13. Harmonische vorhanden sein soll. Nach der Beziehung

$f_h = n \cdot f_v - f_m = (2p + 3) \cdot f_v - f_m$

wurde die Grenzfrequenz des dem Schalter nachgeschalteten Tiefpasses mit $f_h = 13 \cdot 38\,kHz - f_m = 494\,kHz - f_m$ berechnet, wobei $f_h$ die Grenzfrequenz, d.h. der Beginn des Sperrbereiches des Tiefpaßfilters ist, n die Ordnungszahl der ersten vorhandenen Harmonischen (hier 13), p die Anzahl der aufeinanderfolgenden Signalwechsel je Viertelperiode der Wiederholfrequenz $f_v$, $f_v$ die Trägerfrequenz und $f_m$ die Frequenz des dem elektronischen Schalter zugeführten Modulationssignales ist. Die sich nach dem obigen Gleichungssystem ergebenden aufeinanderfolgenden Phasenwinkel $\Phi 1$ bis $\Phi 5$ sind hierbei ein Vielfaches von $1/3°$, um diese Winkelgrade mit dieser Genauigkeit in der Praxis auch erzeugen zu können war bei dem bekannten Modulator ein Taktfrequenzgenerator von 38 kHz $\cdot$ 360 $\cdot$ 3 = 41,04 MHz für den digitalen Impulsgenerator nötig. Diese extrem hohe Taktfrequenz kann nur unter Einsatz von speziellen Bauelementen realisiert werden.

Es ist daher Aufgabe der Erfindung, einen geschalteten Modulator dieser Art so weiterzubilden und zu verbessern, daß der Impulsgenerator mit einer niedrigeren Taktfrequenz betreibbar ist und trotzdem die geforderte Oberwellenunterdrückung erreicht wird.

Diese Aufgabe wird ausgehend von einem Modulator laut Oberbegriff des Hauptanspruches durch dessen kennzeichnende Merkmale gelöst. Eine besonders vorteilhafte Ausge staltung eines solchen Modulators ergibt sich aus dem Unteranspruch 2.

Die Erfindung geht aus von der Erkenntnis, daß aus dem obigen Gleichungssystem zur Berechnung der Phasenwinkel (Abstände) der Signalwechsel Parameter frei werden, wenn die Anzahl der Phasenwinkel und damit auch die Anzahl der Signalwechsel erhöht wird, ohne daß die Forderungen an die Anzahl der zu unterdrückenden Harmonischen verändert werden. Es stehen damit zwar nur p Gleichungen zur Verfügung, um p + x, nämlich eine erhöhte Anzahl von Phasenwinkel zu berechnen. Diese Unbestimmtheit des Gleichungssystems wird jedoch gemäß der Erfindung dadurch berücksichtigt, daß die tatsächliche Grenzfrequenz des Tiefpaßfilters niedriger gewählt wird als der Wert, der sich aus der erhöhten Anzahl p + x der aufeinanderfolgenden Signalwechsel an sich ergeben würde. Damit muß für die nun oberhalb dieser tatsächlichen Grenzfrequenz liegenden ungeraden Harmonischen nicht mehr die Bedingung erfüllt sein, daß deren Amplitudenfaktor A Null (oder in der Praxis beispielsweise kleiner als 60 dB) ist. Es ergeben sich also aus dem Gleichungssystem mehrere Lösungen für die Phasenwinkel $\Phi$. Dieser zusätzliche Freiheitsgrad wird nach der Erfindung dazu ausgenutzt, die Phasenwinkel $\Phi$ nicht mehr auf Bruchteile von Winkelgraden zu berechnen, sondern vielmehr so zu bestimmen, daß sie ein Vielfaches eines größeren Winkels, beispielsweise eine Winkels von $1°$, sind. Solche ganzzahlige Phasenwinkel können damit im Impulsgenerator mit einer geringeren Taktfrequenz technisch realisiert werden, da zu deren Erzeugung keine so große Auflösung mehr nötig ist wie dies für auf Bruchteile genau berechnete Phasenwinkel beim bekannten Modulator nötig ist. Nach einem bevorzugten Ausführungsbeispiel wurde die Anzahl p der aufeinanderfolgenden Signalwechsel zu sechs gewählt und die Grenzfrequenz des Tiefpaßfilters für eine um eins verringerte Anzahl, also für p = 5 nach der Formel $f_h$ = $(2p + 3) \cdot f_v$-$f_m$ für eine Trägerfrequenz von 38 kHz zu 494 kHz - $f_m$ gewählt, damit konnten die Phasenwinkel als ganze Winkelwerte errechnet werden und diese konnten damit mit einer relativ geringen Taktfrequenz von nur 13,68 MHz erzeugt werden. Der Taktgenerator für den Impulsgenerator kann damit mit Bauteilen von niedrigem Leistungsbedarf aufgebaut werden, beispielsweise mit CMOS-Bauelementen, die in integrierter Schaltungstechnik ausgeführt werden können. Trotzdem kann damit ein Modulator mit guter Unterdrückung der Harmonischen im Durchlaßbereich des Filters geschaffen werden.

Die Erfindung wird im folgenden anhand schematischer Zeichnungen an Ausführungsbeispielen näher erläutert.

Fig. 1 zeigt das Prinzipschaltbild eines geschalteten Modulators mit gemäß der Erfindung bemessener Ausgangsimpulsfolge und zwar angewendet zum Erzeugen von nach dem Pilottonverfahren codierten Stereotonsignalen.

Fig. 2 zeigt die Zeitfunktion der zur Steuerung benutzten Impulsfolge.

Fig. 3 beschreibt das der Erfindung zugrunde liegende Gleichungssystem.

Der geschaltete Modulator gemäß Fig. 1 besteht aus einem Impulsgenerator 1 dessen Ausgang mit dem Steuereingang eines elektronischen Schalters 2 verbunden ist. Der elektronische Schalter 2 ist ein Umschalter mit zwei Eingängen und einem Ausgang. Bei Verwendung des Modulators zur Erzeugung eines stereocodierten Signals werden den beiden Modulationseingängen des Umschalters 2 die Ausgangssignale des rechten und linken Kanals einer Stereosignalquelle 4 zugeführt, so daß am Ausgang des Schalters 2 das stereocodierte Signal ohne Pilotsignal entsteht, das aus dem Summensignal der beiden Kanäle und einem Differenzsignal der beiden Kanäle moduliert mit der Trägerfrequenz von beispielsweise 38 kHz und höheren Harmonischen ab einer vorbestimmten Ordnungszahl besteht. Der elektronische Schalter 2 wird durch die Ausgangsimpulsfolge gemäß Fig. 2 des digitalen Impulsgenerators 1 geschaltet (L- bzw. H-Potential der Impulsfolge). Am Ausgang des Schalters 2 ist ein Tiefpaßfilter 3 angeschaltet, das die unerwünschten Harmonischen höherer Ordnung entfernt, so daß das Ausgangssignal dieses Filters nur das Summensignal und das gewünschte modulierte Differenzsignal enthält. Die Ausgangsimpulsfolge gemäß Fig. 2 wird nach dem eingangs erklärten Gleichungssystem berechnet und zwar werden nach diesem Gleichungssystem jeweils für eine Viertelperiode ($\pi/2$) der Wiederholfrequenz

dieser Ausgangsimpulsfolge die zugehörigen Phasenwinkel $\Phi1$ - $\Phi n$ berechnet und in einem Speicher im Impulsgenerator 1 abgelegt. Diese abgespeicherten Werte zur Erzeugung der Impulsfolge nach Fig. 2 werden über einen Taktgenerator 10 aus dem Impulsgenerator 1 ausgelesen und die hierdurch entstehende Ausgangsimpulsfolge nach Fig. 2 am Ausgang des Impulsgenerators 1 steuert den Schalter 2.

In einem praktischen Ausführungsbeispiel wurde die Ausgangsimpulsfolge nach Fig. 2 wie folgt festgelegt:

Die Trägerfrequenz $f_v$ ist mit 38 kHz gegeben. Es wurde vorgegeben, daß die erste nicht unterdrückte Harmonische von 13. Ordnung sein soll, n also 13 ist. Nach der bekannten Beziehung $f_h$ = n $\cdot f_v$ - $f_m$ wurde die Grenzfrequenz $f_h$ des Ausgangsfilters 3 zu 494 kHz - $f_m$ gewählt. Die Anzahl der Phasenwinkel, die der Anzahl der entsprechenden Signalwechsel je Viertelperiode entspricht, wurde jedoch nicht wie bekannt nach der Beziehung p = (n - 3)/2 = (13 - 3)/2 = 5 gewählt, sondern vielmehr mit p = 6 gewählt (nach der bekannten Berechnungsart hätte dies ein Tiefpaßfilter von 570 kHz - $f_m$ erlaubt). Diese höhere Anzahl von aufeinanderfolgenden Signalwechseln ergibt nach obigem Gleichungssystem einen größeren Freiheitsgrad für die Berechnung der Phasenwinkel für die Signalwechsel. Nach Optimierung ergaben sich folgende Winkel in der ersten Viertelperiode der Wiederholfrequenz:

$\Phi1$ = 35°, $\Phi2$ = 37°, $\Phi3$ = 56°, $\Phi4$ = 61°, $\Phi5$ = 75°, $\Phi6$ = 82°.

Aus Bedingung (I) und (II) ergibt sich, daß in gleicher Weise die Phasenwinkel in den folgenden Viertelperioden sich entsprechend wiederholen.

Diese Winkel sind nicht mehr Vielfaches eines sehr kleinen Winkels (z.B. 1/3°), sondern Vielfaches eines größeren Winkels (in diesem Fall 1°), so daß sie mit einer wesentlich geringeren Taktfrequenz des Impulsgenerators 10 erzeugt werden können, es genügt für dieses Ausführungsbeispiel beispielsweise eine Taktfrequenz von nur noch 38 kHz $\cdot$ 360 = 13,68 MHz. Da die Grenzfrequenz des Tiefpaßfilters 3 bedeutend höher liegt als das Spektrum des auf diese Weise erzeugten stereocodierten Ausgangssignals, das bis 53 kHz reicht, treten nur sehr kleine Amplituden- und Phasenfehler auf.

Die Erzeugung der in Fig. 2 dargestellten Ausgangsimpulsfolge kann in an sich bekannter Weise (Proceedings of the RF-Technology Expo, S. 67) beispielsweise dadurch erfolgen, daß die Zeitabstände zwischen den aufeinanderfolgenden Einzelimpulsen in einem Speicher (ROM oder PROM) an aufeinanderfolgenden Adressen gespeichert werden und über diesen Speicher ein Zähler gesteuert wird. Gemäß einer Weiterbildung der Erfindung ist es jedoch vorteilhaft, die Ausgangsimpulsfolge nach Fig. 2 unmittelbar als Digitalwert in der Tiefe eines Speichers (PROM), also in Richtung aufsteigender Adressen, zu speichern und diese Digitalwertfolge über einen vom Taktgenerator 10 gesteuerten Adressenzähler direkt am Datenausgang des Speichers auszulesen. Für das obengenannte Beispiel einer Ausgangsimpulsfolge mit sechs Phasenwinkeln Φ1 bis Φ6 je Viertelperiode und einer Schrittweite von 1° muß der Speicher eine Tiefe von 360 Adressen besitzen, damit eine volle Periode (360°) in einem Bit jeder Adresse gespeichert werden kann. Für das obengenannte Beispiel ist also für Φ1 = 35° an einem Bit des Speichers in 35 aufeinanderfolgenden Adressen jeweils der Digitalwert "1", der nach der Impulsfolge von Fig. 2 dem Wert "H" entsprechen soll, gespeichert, auf den nächsten beiden Adressen 36 und 37 ist im Speicher eine "0" gespeichert, die dem Wert "L" nach Fig. 2 entspricht und den zweiten Winkel Φ2 definiert, anschließend ist dann wieder an darauffolgenden 19 Adressen jeweils eine "1" gespeichert, die den Abstand Φ2 bis Φ3 des Signals nach Fig. 2 als "H" definieren usw.. Wenn diese Digitalwerte (Folge von "1" und "0") mittels eines Adressenzählers, der über den Taktgenerator 10 gesteuert ist, nacheinander aus dem Speicher ausgelesen werden, so entsteht am Datenausgang des Speichers unmittelbar die gewünschte Ausgangsimpulsfolge nach Fig. 2, mit der dann unmittelbar der elektronische Schalter 2 angesteuert werden kann. Wenn die Digitalwertfolge parallel nebeneinander an mehreren Bits des Speichers abgespeichert wird kann die Tiefe des Speichers geringer sein. Wenn beispielsweise die Digitalwertfolge an vier nebeneinanderliegenden Bits des Speichers abgespeichert wird, so muß der Speicher nicht mehr eine Tiefe von 360 Adressen, sondern nur mehr von 90 Adressen besitzen. Die an mehreren nebeneinanderliegenden Bits abgespeicherten Digitalwerte können mittels eines über den Taktgenerator 10 gesteuerten Multiplexers parallel ausgelesen und in entsprechende serielle Datenfolge rückgewandelt werden, auch in diesem Fall entsteht am Ausgang des Multiplexers unmittelbar die Ausgangsimpulsfolge nach Fig. 2, mit der dann unmittelbar der Schalter 2 angesteuert werden kann. Auf diese Weise kann die Wortbreite moderner Speicher (PROM) besser genutzt und die Speichertiefe reduziert werden.

Diese Art der unmittelbaren Erzeugung der Ausgangsimpulsfolge am Datenausgang eines Speichers macht es ferner möglich, daß in der Breite des Speichers neben der Digitalwertfolge der Ausgangsimpulsfolge gemäß Fig. 2 an danebenliegenden Bits noch andere Digitalwerte gespeichert sind, die beim gemeinsamen Auslesen mit der Digitalwertfolge für die Erzeugung des Signals nach Fig. 2 an den entsprechenden Datenausgängen des Speichers dann unmittelbar Impulsfolgen erzeugen, die mit der Ausgangsimpulsfolge nach Fig. 2 synchron sind. Auf diese Weise kann unmittelbar synchron mit der Ausgangsimpulsfolge nach Fig. 2 beispielsweise das 19 kHz-Pilotsignal für das Stereotonsignal erzeugt werden, das exakt in Phase mit dem 38 kHz-Träger erzeugt werden muß. In gleicher Weise können auch noch andere Signale im Speicher als Digitalwert abgespeichert werden, die synchron mit der Ausgangsimpulsfolge nach Fig. 2 erzeugt werden sollen, beispielsweise die zusammen mit der FM-Übertragung von Stereotonsignalen benutzten Hilfsdienste für Verkehrsdurchsagen (ARI), für Radio-Datensysteme (RDS), SCA-Anwendungen und dergleichen. Diese gemeinsam aus dem Speicher ausgelesenen Signale sind zwar im Prinzip synchron, zur Unterdrückung von unerwünschten Flankenzuständen (Glitches) kann es jedoch noch vorteilhaft sein, eine zusätzliche Zwischenspeicherung in Flip-Flops vorzusehen, aus denen dann die Signalfolgen exakt synchron ausgelesen werden.

Mit der synchron zum Signal nach Fig. 2 erzeugten 19 kHz-Pilotsignal-Impulsfolge kann in an sich bekannter Weise beispielsweise unmittelbar ein zweiter elektronischer Schalter angesteuert werden, der dann, wenn am Modulationseingang eine symmetrische Gleichspannung angelegt ist, unmittelbar das 19 kHz-Pilotsignal liefert.

Wenn zwischen den synchron aus dem Speicher auslesbaren Signalen eine vorbestimmte Phasenverschiebung erreicht werden soll, wie dies beispielsweise zwischen dem Pilotsignal und den Stereosignalen der Fall sein kann, so kann dies auf einfache Weise durch ein Schieberegister oder eine andere einstellbare Verzögerungsschaltung erfolgen, die in den Weg der Ausgangsimpulsfolge angeordnet wird.

In einem derartigen System mit Erzeugung der verschiedenen Signale auf digitalem Wege in einem Speicher ist auch leicht eine Änderung der Phasenlagen und eine Anpassung an verschiedene Stereonormen möglich, dazu ist es nur erforderlich, einen elektrisch löschbaren und wieder beschreibbaren Speicher (EEPROM oder RAM) zu verwenden.

Anstelle der analogen Modulation mit Hilfe eines elektronischen Schalters 2 ist nach dem erfindungsgemäßen Prinzip auch eine unmittelbare digitale Modulation möglich. Dazu ist es nur erforderlich, das zu modulierende Signal, beispielsweise die beiden Ausgangssignale des rechten und linken Kanals der Stereosignalquelle 4, mittels eines Analog/Digital-Wandlers zu digitalisieren - falls dieses Signal nicht bereits schon als Digitalwert angeboten wird - und diese aufeinanderfolgenden Digitalwerte mit den Digitalwerten der Ausgangsimpulsfolge nach Fig. 2 zu sortieren, d.h. diejenigen Digitalwerte des Modulationssignals, die zwischen 0° und Φ1 des Signals nach Fig. 2 auftreten (H-Potential der Impulsfolge), an den Ausgang abzugeben während die darauffolgenden Digitalwerte zwischen Φ1 und Φ2 (L-Potential der Impulsfolge) unterdrückt werden. Für die Modulation der beiden Ausgangssignale des rechten und linken Kanals eines Stereosignals, bei welcher eine Umschaltung zwischen den beiden Kanälen gewünscht wird, bedeutet dies, daß zwischen 0° und Φ1 des Signals nach Fig. 2 (dargestellt durch den Digitalwert "1" im Speicher) beispielsweise die Digitalwerte des linken Kanals zum Ausgang durchgeschaltet werden während zwischen Φ1 und Φ2 (dargestellt durch den Digitalwert "0" im Speicher) die Digitalwerte des rechten Kanals der Stereosignalquelle zum Ausgang durchgeschaltet werden. Auf diese Weise kann also rein rechnerisch in einem Mikroprozessor ein moduliertes Ausgangssignal erzeugt werden, das dann vorzugsweise in einem ebenfalls digitalen Filter, das nach der erfindungsgemäßen Bemessungsvorschrift bemessen ist, gefiltert wird. Die quasi durch die Digitalwerte der Ausgangsimpulse nach Fig. 2 sortierten Digitalwerte des Modulationssignals, die als Digitalwertfolge am Ausgang auftreten, können anschließend durch einen Digital/Analog-Wandler in ein analoges moduliertes Ausgangssignal umgewandelt werden, falls nicht eine anschließende reine digitale Weiterverarbeitung des Signals gewünscht wird.

**Patentansprüche**

1. Geschalteter Modulator, insbesondere zum Erzeugen von nach dem Pilottonverfahren codierten Stereotonsignalen, mit einem durch einen Taktgenerator (10) gesteuerten digitalen Impulsgenerator (1), durch dessen Ausgangsimpulsfolge (11) mindestens ein elektronischer Schalter (2) gesteuert ist, wobei die Wiederholfrequenz ($f_v$) dieser Ausgangsimpulsfolge der Trägerfrequenz (z.B. 38 kHz) entspricht und die Anzahl (p) sowie die Abstände (Phasenwinkel Φ) der aufeinanderfolgenden Signalwechsel so gewählt sind, daß von der Wiederholfrequenz nur Harmonische (n · $f_v$) entstehen, die oberhalb der Grenzfrequenz ($f_h$) eines dem elektronischen Schalter (2) nachgeschalteten Tiefpaßfilters (3) liegen, dadurch **gekennzeichnet,** daß die Anzahl (p) der aufeinanderfolgenden Signalwechsel größer gewählt ist (z.B. 6) als die sich aus der vorgegebenen Grenzfrequenz ($f_h$) des Tiefpaßfilters (3) ergebende Anzahl von Signalwechseln (bei $f_h$ = 494 kHz - $f_m$ z.B. 5), daß der Impulsgenerator (1) eine Ausgangsimpulsfolge erzeugt, deren kleinster Abstand der aufeinanderfolgenden Signalwechsel der Periode des Ausgangssignales des Taktgenerators (10) entspricht und daß für den Taktgenerator (10) eine niedrigere Taktfrequenz (z.B. 13,68 MHz) verwendet wird als die niedrigste verwendbare Taktfrequenz, die sich aus der aus der Grenzfrequenz ($f_h$) des Tiefpaßfilters (3) resultierenden Anzahl von Signalwechsel ergibt.

2. Modulator nach Anspruch 1, dadurch **gekennzeichnet,** daß die Grenzfrequenz ($f_h$) des Tiefpaßfilters (3) noch für die Unterdrückung der 13. Harmonischen gewählt ist (n = 13) und sechs Signalwechsel je Viertelperiode der Wiederholfrequenz benutzt werden, wobei die die Abstände definierenden Phasenwinkel (Φ) in der ersten Viertelperiode zu
Φ1 = 35°, Φ2 = 37°, Φ3 = 56°, Φ4 = 61°, Φ5 = 75° und Φ6 = 82°
gewählt sind.

3. Modulator nach Anspruch 1 oder 2, dadurch **gekennzeichnet,** daß die Ausgangsimpulsfolge (11) als Digitalwert in der Tiefe (aufsteigende Adressen) eines Speichers (PROM) gespeichert und über einen vom Taktgenerator (10) gesteuerten Adressenzähler direkt auslesbar ist.

4. Modulator nach Anspruch 3, dadurch **gekennzeichnet,** daß neben dem Digitalwert der Ausgangsimpulsfolge mindestens noch ein weiteres mit dieser Ausgangsimpulsfolge synchron zu erzeugendes Signal ebenfalls als Digitalwert in benachbarten Bits des Speichers (PROM) gespeichert und ebenfalls direkt auslesbar ist.

5. Modulator nach Anspruch 3 oder 4, dadurch **gekennzeichnet,** daß die Digitalwerte im Speicher in mehreren Bits einer Adresse gespeichert und über vom Taktgenerator gesteuerte Multiplexer auslesbar sind.

6. Modulator nach einem der vorhergehenden Ansprüche, dadurch **gekennzeichnet,** daß das auf den Träger aufzumodulierende Modulationssignal, insbesondere das Stereotonsignal, digitalisiert wird und in einem Signalprozessor diese Digitalwerte durch die Digitalwerte der Ausgangsimpulsfolge (11) so ausgewählt werden, daß ein digital erzeugter modulierter Träger entsteht.

7. Modulator nach Anspruch 6, dadurch **gekennzeichnet,** daß der digital erzeugte modulierte Träger in einem digitalen Filter gefiltert wird.

**8.** Modulator nach einem der vorhergehenden Ansprüche 3 bis 7, dadurch **gekennzeichnet,** daß der die Ausgangsimpulsfolge und gegebenenfalls weitere Signalfolgen speichernde Speicher ein elektrisch lösch- und beschreibbarer Speicher (EEPROM bzw. RAM) ist.

## Claims

**1.** Switched modulator, particularly one for producing stereo sound signals coded by the pilot tone method, having a digital pulse generator (1) controlled by a clock generator (10) and by the output pulse train (11) of which pulse generator (1) at least one electronic switch (2) is controlled, the repetition frequency ($f_v$) of said output pulse train corresponding to the carrier frequency (e.g. 38 kHz) and the number (p) and the spacings (phase angles $\Phi$) of the successive signal changes being selected such that of the repetition frequency the only harmonics ($n \cdot f_v$) that occur are above the cut-off frequency ($f_h$) of a low-pass filter (3) connected downstream of the electronic switch (2), characterised in that the number (p) of successive signal changes is greater (e.g. 6) than the number of signal changes (e.g. 5 at $f_h$ = 494 kHz - $f_m$) resulting from the preset cut-off frequency ($f_h$) of the low-pass filter (3), in that the pulse generator (1) generates an output pulse train of which the smallest spacing of the successive signal changes corresponds to the cycle of the output signal from the clock generator (10) and in that a lower clock frequency (e.g. 13.68 MHz) is used for the clock generator (10) than the lowest usable clock frequency resulting from the number of signal changes resulting from the cut-off frequency ($f_h$) of the low-pass filter (3).

**2.** Modulator according to claim 1, characterised in that the cut-off frequency ($f_h$) of the low-pass filter (3) is additionally chosen for suppression of the 13th harmonic (n = 13) and six signal changes are utilised per quarter-cycle of the repetition frequency, the phase angles ($\Phi$) defining the spacings being chosen in the first quarter-cycle to be
$\Phi 1 = 35°$, $\Phi 2 = 37°$, $\Phi 3 = 56°$, $\Phi 4 = 61°$, $\Phi 5 = 75°$, $\Phi 6 = 82°$.

**3.** Modulator according to claim 1 or 2, characterised in that the output pulse train (11) is stored as a digital value in the depth (ascending addresses) of a memory (PROM) and can be read out direct by way of an address counter controlled by the clock generator (10).

**4.** Modulator according to claim 3, characterised in that in addition to the digital value of the output pulse train at least one other signal to be generated synchronously with said output pulse train is likewise stored as a digital value in neighbouring bits of the memory (PROM) and can likewise be read out direct.

**5.** Modulator according to claim 3 or 4, characterised in that the digital values in the memory are stored in a plurality of bits of one address and can be read out by way of multiplexers controlled by the clock generator.

**6.** Modulator according to any of the preceding claims, characterised in that the modulation signal to be modulated onto the carrier, in particular the stereo sound signal, is digitised and in a signal processor these digital values are selected by the digital values of the output pulse train (11) so as to produce a digitally generated modulated carrier.

**7.** Modulator according to claim 6, characterised in tht the digitally generated modulated carrier is filtered in a digital filter.

**8.** Modulator according to any of preceding claims 3 to 7, characterised in that the memory storing the output pulse train and any additional signal trains is an electrically erasable and writeable memory (EEPROM or RAM).

## Revendications

**1.** Modulateur commuté, notamment pour générer des signaux de sons stéréophoniques codés selon le procédé du son pilote, avec un générateur d'impulsions numériques (1) commandé par un générateur d'horloge (10), et dont la suite des impulsions de sortie (11) commande au moins un commutateur électronique (2), la fréquence de répétition ($f_v$) de cette suite des impulsions de sortie correspond à la fréquence porteuse (par exemple 38 kHz) et le nombre (p) ainsi que l'écartement (angle de phase $\Phi$) des alternances successives du signal sont choisis pour que la fréquence de répétition n'engendre que les harmoniques ($n \cdot f_v$) situées au-dessus de la fréquence limite ($f_h$) d'un filtre passe-bas (3) en aval du commutateur électronique (2), modulateur caractérisé en ce que le nombre (p) des alternances successives de signal est choisi supérieur (par exemple 6) au nombre d'alternances de signal résultant de la fréquence limite ($f_h$) prédéterminée du filtre passe-bas (13) (pour $f_h$ = 494 kHz - $f_m$, par exemple 5) le générateur d'impulsions (1) générant une suite d'impulsions de sortie dont l'écartement le plus faible des alternances successives du signal correspond à la période du signal de sortie du générateur d'horloge (10), et l'on utilise pour le générateur d'horloge (10) une fréquence de cadence (horloge) plus faible (par exemple 13,68 MHz) que la fréquence d'horloge la plus faible utilisable, découlant du nombre d'alternances de signal résultant de la fréquence limite ($f_h$) du filtre passe-bas (3).

2. Modulateur selon la revendication 1, caractérisé en ce que la fréquence limite ($f_h$) du filtre passe-bas (3) est choisie pour supprimer encore la troisième harmonique (n = 13), en ce qu'on utilise six alternances de signal pour chaque quart de période de la fréquence de répétition, et en ce que les angles de phase ($\Phi$) qui définissent les intervalles dans le premier quart de période, sont choisis comme suit :
$\Phi 1 = 35°$, $\Phi 2 = 37°$, $\Phi 3 = 56°$, $\Phi 4 = 61°$, $\Phi 5 = 75°$, $\Phi 6 = 82°$.

3. Modulateur selon la revendication 1 ou 2, caractérisé en ce que la suite des impulsions de sortie (11) est enregistrée comme des valeurs numériques dans le fond (adresses croissantes) d'une mémoire (PROM) et qui se lisent directement par un compteur d'adresses commandé par le générateur d'horloge (10).

4. Modulateur selon la revendication 3, caractérisé en ce qu'à côté de la valeur numérique de la suite des impulsions de sortie, on enregistre et on lit également directement au moins un autre signal à générer en synchronisme avec cette suite d'impulsions de sortie, également sous forme de valeurs numériques dans les bits voisins de la mémoire (PROM).

5. Modulateur selon la revendication 3 ou 4, caractérisé en ce que les valeurs numériques sont enregistrées dans la mémoire, dans plusieurs bits d'une adresse et peuvent être lus par un multiplexeur commandé par le générateur d'horloge.

6. Modulateur selon l'une des revendications précédentes, caractérisé en ce qu'on numérise le signal de modulation modulé sur la porteuse, notamment le signal de son stéréophonique et en ce qu'on sélectionne dans un processeur de signal, ces valeurs numériques par les valeurs numériques de la suite des impulsions de sortie (11) pour obtenir une porteuse modulée, générée de manière numérique.

7. Modulateur selon la revendication 6, caractérisé en ce que la porteuse modulée, générée de manière numérique est filtrée dans un filtre numérique.

8. Modulateur selon l'une des revendications précédentes 3 à 7, caractérisé en ce que la mémoire qui enregistre la suite des impulsions de sortie et le cas échéant d'autres suites de signaux, est une mémoire inscriptible et effaçable électriquement (mémoire EEPROM ou mémoire RAM).

Fig. 1:

Fig. 2:

$$H$$

$$\Phi_1 \ \Phi_2 \ \Phi_3 \ \Phi_4 \ \Phi_5 \ \Phi_6 \qquad \pi - \Phi_1 \qquad \pi + \Phi_1 \qquad 2\pi - \Phi_1$$

Fig. 3:

$$A_1 = \frac{4}{\pi}\left[\ 2\sin\Phi_1 - 2\sin\Phi_2 + \ldots + (-1)^{(p-1)}\cdot 2\sin\Phi_{(p-1)} + (-1)^p\, 2\sin\Phi_p + (-1)^{(p+1)}\sin\frac{\pi}{2}\ \right]$$

$$A_3 = \frac{4}{3\pi}\left[\ 2\sin 3\Phi_1 - 2\sin 3\Phi_2 + \ldots + (-1)^{(p-1)}\cdot 2\sin 3\Phi_{(p-1)} + (-1)^p\, 2\sin 3\Phi_p + (-1)^{(p+1)}\sin 3\frac{\pi}{2}\ \right]$$

$$\vdots$$

$$A_n = \frac{4}{n\pi}\left[\ 2\sin n\Phi_1 - 2\sin n\Phi_2 + \ldots + (-1)^{(p-1)}\cdot 2\sin n\Phi_{(p-1)} + (-1)^p\, 2\sin n\Phi_p + (-1)^{(p+1)}\sin n\frac{\pi}{2}\ \right]$$

8